# EUROPÄISCHE PATENTSCHRIFT

(11) **EP 3 469 635 B1**
(45) Veröffentlichungstag und Bekanntmachung des Hinweises auf die Patenterteilung: **09.09.2020**
(21) Anmeldenummer: 18704393.0
(22) Anmeldetag: 25.01.2018
(51) Int. Cl.: H01L 31/048

(54) **VERFAHREN UND VORRICHTUNG ZUM TRENNEN VERSCHIEDENER MATERIALSCHICHTEN EINES VERBUNDBAUTEILS**
METHOD AND DEVICE FOR SEPARATING DIFFERENT MATERIAL LAYERS OF A COMPOSITE COMPONENT
PROCÉDÉ ET DISPOSITIF POUR SÉPARER DES COUCHES DE MATÉRIAU DIFFÉRENTES D'UN ÉLÉMENT COMPOSITE

(30) Priorität: 26.01.2017 DE 102017101564; 20.04.2017 DE 102017108417; 14.06.2017 WO PCT/EP2017/064614
(43) Veröffentlichungstag der Anmeldung: 17.04.2019
(73) Patentinhaber: Gross, Leander Kilian, 01465 Langebrück (DE); Gross, Mascha Elly, 01465 Langebrück (DE)
(72) Erfinder: GROSS, Harald, 01465 Langebrück (DE)
(74) Vertreter: Lippert Stachow Patentanwälte Rechtsanwälte Partnerschaft mbB
(86) Internationale Anmeldenummer: PCT/DE2018/100062
(87) Internationale Veröffentlichungsnummer: WO 2018/137735

(56) Entgegenhaltungen:
- EP-A2- 2 133 923
- US-A1- 2009 183 825
- US-A1- 2011 108 108
- LARS REBOHLE ET AL: "A review of thermal processing in the subsecond range: semiconductors and beyond", SEMICONDUCTOR SCIENCE AND TECHNOLOGY, IOP PUBLISHING LTD, GB, Bd. 31, Nr. 10, 1. September 2016 (2016-09-01), Seite 103001, XP020308832, ISSN: 0268-1242, DOI: 10.1088/0268-1242/31/10/103001 [gefunden am 2016-09-01]

## Beschreibung

Die Erfindung betrifft ein Verfahren zum Trennen verschiedenartiger Materialschichten eines Verbundbauteils, welches mindestens eine für sichtbares Licht transparente Materialschicht, mit einer Transparenz über 40%, und mindestens eine weitere Materialschicht umfasst, wobei das Licht einer externen Quelle durch die mindestens eine transparente Materialschicht in die mindestens eine weitere Materialschicht fällt und dort zumindest teilweise absorbiert wird.

Derartige Verbundbauteile weisen einen Gewichtsanteil an Glas von 50% oder mehr auf. Die Anwendung bei geringen Gewichtsanteilen von Glas ist ebenso möglich.

Solarzellenmodule fallen unter die Kategorie "Elektronikschrott" und müssen nach EU-Richtlinien recycelt werden. Die Module enthalten je nach Bauart wertvolle Bestandteile wie Silizium-Wafer und Silber oder seltene Stoffe wie Indium, Gallium oder Tellur.

Typischerweise werden Solarmodule in kleine Bestandteile zermahlen und anschließend die im Granulat enthaltenen Stoffe mit mechanischen sowie chemischen Verfahren voneinander getrennt. Bei neueren Verfahren wird das gesamte Modul in einem Ofen erhitzt, sodass die enthaltenen Kunststoffe verbrennen. Die übrig gebliebenen Bestandteile wie z.B. Glas und Silizium-Wafer werden nach dem Ofenprozess mechanisch voneinander getrennt und anschließend chemisch aufbereitet und gereinigt, sodass diese wieder in der Produktion verwendet werden können.

In der US 2009/0183825 A1 wird beschrieben, dass eine Trennung der Deckgläser möglich ist, wenn ein Polymer zur Verbindung beider Glassubstrate verwendet wurde. Mittels UV-Strahlung über bis zu drei Stunden oder Heizung, bei denen das Verbundsystem Temperaturen von einigen hundert Grad Celsius ausgesetzt wird, können bestimmte chemische Verbindungen getrennt werden.

Ein Dünnschichtsolarzellenmodul besteht im Wesentlichen aus zwei Glasscheiben mit jeweils einer Dicke von ungefähr 2.0 bis 3.0 Millimetern, einer dazwischen laminierten Folie, z.B. aus EVA (Ethylen-Vinyl-Acetat) mit einer Dicke von ungefähr 0.2 bis 0.4 Millimetern sowie einer stromerzeugenden Schicht mit einer Dicke von ungefähr 0.003 Millimetern, welche zwischen der Folie und einer der beiden Glasscheiben eingebettet ist. Hinsichtlich des Volumens besteht ein Dünnschichtsolarzellenmodul somit zum überwiegenden Teil aus Glas, welches das zuvor beschriebene Zermahlen und die anschließende chemische Auftrennung der Materialien als Recycling-Methode unökonomisch macht. Auch der hohe Energiebedarf für den oben beschriebenen Ofenprozess sowie die damit verbundene lange Prozessdauer von teilweise mehreren Stunden bietet eine hohe Motivation für die Suche nach alternativen Recycling-Verfahren.

In der Patentanmeldung "Recycling-Verfahren für Dünnschichtsolarzellenmodule" (EP 2 133 923 A2) wird ein Verfahren beschrieben, welches durch Rastern eines Laserstrahls auf der Oberfläche eines Dünnschichtsolarzellenmoduls die lichtabsorbierende und damit stromerzeugende Schicht des Moduls erhitzt und damit eine Trennung der beiden Glasscheiben verursacht.

Anschließend kann in chemischen Bädern die stromerzeugende Schicht abgelöst werden und die EVA-Folie mechanisch abgezogen werden. Erst die Trennung der Glasscheiben voneinander ermöglicht dabei die effektive Einwirkung der Chemikalien auf die zwischen den Glasscheiben enthaltenen Schichten.

Der größte Nachteil der bekannten Verfahren zum Recycling von Solarmodulen ist neben den hohen Investitionskosten der umfangreiche Zeitbedarf. Auch Beim Lasern werden einige Minuten für das Rastern des Strahls über die gesamte Fläche einer Seite des Solarmoduls von ungefähr ein bis eineinhalb Quadratmetern benötigt. Wenn man eine heutzutage übliche Größe eines Solarparks mit einer Spitzenleistung von ungefähr 300 Megawatt annimmt, so sind dort ca. zwei Millionen Dünnschichtsolarmodule installiert. Ein Laser würde also viele Jahre damit beschäftigt sein die beiden Glasscheiben der Module des Solarparks zu zerlegen.

Gemäß Anspruch 1 der Erfindung wurde ein Verfahren entwickelt, welches mit Hilfe des von mindestens einer Gasentladungslampen generierten Lichts eine lichtabsorbierende weitere Materialschicht eines Verbundbauteils in einem Belichtungsfeld, welches mindestens einen Anteil der Oberfläche des Verbundbauteils umfasst, in weniger als einer Sekunde bestrahlt und erhitzt. Mittels der Gasentladungslampe oder mehreren davon kann das gesamte Belichtungsfeld gleichzeitig bestrahlt und die lichtabsorbierende Materialschicht erhitzt werden.

Die mindestens eine Gasentladungslampe wird als Blitzlampe betrieben, sodass die in das Verbundbauteil eingetragene Energie zu einer vernachlässigbaren Erhöhung der Temperatur des gesamten Verbundbauteils führt.

Somit wird im Belichtungsfeld unter Ausnutzung geeigneter thermischer oder unter Lichteinwirkung verursachter chemischer Prozesse oder infolge thermo-mechanischer Spannungen, welche Folge der Temperaturgradienten oder unterschiedlichen Wärmeausdehnungskoeffizienten der Materialien sind, oder Kombinationen dieser Prozesse, nachfolgend allgemein als Trennprozesse bezeichnet, die Trennung der Materialschichten des Verbundbauteils bewirkt. Dabei genügt es eine, meist nur wenige Mikrometer dicke Lage entlang der Grenzfläche der zu trennenden Materialien von einer Ausgangstemperatur, z.B. Raumtemperatur, um typischerweise mehrere hundert Grad Kelvin auf die erforderliche Prozesstemperatur zu erhitzen. So können, insbesondere bei einer möglichst dünnschichtiger Erhitzung, hohe Erwärmungs- und/oder Abkühlraten und damit Bestrahlungszeiten von weniger als einer Sekunde genutzt werden, die mit der benötigten Energiedichte durch Blitzlampen bereitgestellt werden können.

Die Bestrahlungszeiten können in Abhängigkeit von verschiedenen Parametern, wie den im Verbundbauteil verwendeten Materialien, der Größe des Verbundbauteils bzw. der bestrahlten Teilfläche und anderen, variiert werden. So können Bestrahlungszeiten von einer Millisekunde, zehn, zwanzig, fünfzig, hundert, fünfhundert oder mehr Millisekunden oder beliebige Zwischenwerte verwendet werden. Der Fachmann kann durch Simulation oder Versuche oder eine Kombination von beidem die optimalen Bestrahlungszeiten für das zu behandelnde Verbundbauteil ermitteln und auswählen, sodass die in das Verbundbauteil eingetragene Energie zu einer vernachlässigbaren Erhöhung der Temperatur des gesamten Verbundbauteils führt.

Mit Hilfe der Blitzlampe fällt das Licht der Lampe durch eine für Licht transparente Materialschicht des Verbundbauteils und wird von einer weiteren Materialschicht oder mehreren davon absorbiert. Die durch die Lichtabsorption ausgelösten Trennprozesse, beispielsweise eine Temperaturerhöhung von mehreren hundert Grad Kelvin oder das durch die Lichteinwirkung verursachte Aufbrechen von chemischen Bindungen, an oder in unmittelbarer Nähe der Grenzfläche bewirken die Trennung von mindestens zwei Materialschichten des Verbundbauteils voneinander. Mit dem beschriebenen Verfahren können die an die transparente Materialschicht angrenzende weitere Materialschicht und/oder zumindest eine der von der transparenten Materialschicht entfernter liegenden weiteren Materialschichten von der oder den benachbarten Materialschichten getrennt werden. Infolge der im gesamten Belichtungsfeld konstanten Intensität des Lichts, zu einem beliebigen Zeitpunkt der Belichtung betrachtet, werden im Belichtungsfeld auf der Fläche homogene Trennprozesse ausgelöst und eine gleichförmige Trennung der Materialschichten erzielt.

Die eigentliche Trennung der Materialschichten kann weitere, nachfolgend beispielhaft und nicht beschränkend, beschriebene Verfahrensschritte erfordern, die an sich erst die gegenständliche Trennung ermöglichen oder unmittelbar durch die Ablösung der Grenzflächen voneinander erfolgen. Die ergänzenden Verfahrensschritte können separat und zu einem späteren Zeitpunkt ausgeführt werden.

Die Größe des Belichtungsfeldes, d. h. der mit einer Belichtung behandelte Anteil der Oberfläche des Verbundmaterials, kann entsprechend verschiedener Parameter, wie dem Schichtaufbau des Verbundbauteils, dessen Materialien mit deren physikalischen und chemischen Eigenschaften, der Gesamtgröße des Verbundbauteils, der für den verwendeten thermischen Prozess benötigten und mit der Lichtquelle erzielbaren Leistungsdichte, dem zur Verfügung stehenden Platz und anderen Parametern, sehr unterschiedlich gewählt werden. In Experimenten wurde gezeigt, dass ein Feld mehrerer zylinderförmiger und parallel angeordneter Blitzlampen die gesamte Oberfläche eines Moduls homogen beleuchten kann, sodass beispielsweise bei Photovoltaikmodulen die Trennung der Glasscheiben des gesamten Moduls mit nur einer Belichtung und damit innerhalb weniger als einer Sekunde möglich ist.

Anwendung findet dieses Verfahren beispielsweise beim Recycling von Photovoltaik-Modulen, beispielsweise von Glasscheiben und Schichtmaterialien eines Dünnschichtmoduls, Displays oder Komponenten der sogenannten "Concentrated Solar Power".

Die Unterscheidung der Materialschichten in transparente und weitere, lichtabsorbierende Schichten erfolgt nach deren für den Trennungsprozess verwendeten und vorherrschenden optischen Verhalten. So bildet die transparente Materialschicht das Eintrittsfenster zumindest für das sichtbare Licht der externen Strahlungsquelle in das Verbundbauteil und hat zu diesem Zweck eine Transparenz für den für den zur Anwendung kommenden Trennprozess verwendeten Spektralbereich. Materialschichten mit einer Transparenz für sichtbares Licht von über 40% haben sich für die nutzbaren Prozesse als geeignet erwiesen, wobei sich die Prozentangaben der Transparenz auf das Emissionsspektrum der regelmäßig breitbandig emittierenden Blitzlampe beziehen. In Abhängigkeit von der verwendeten Blitzlampe, deren Betriebsparameter, vom verwendeten Trennprozess sowie von den Schichtmaterialien kann die spektrale Transparenz neben dem sichtbaren auch andere Bereiche des Emissionsspektrums einschließen, wie beispielsweise Licht im UV-Bereich und/oder IR-Bereich.

Das Verfahren kann auch auf Verbundbauteile angewendet werden, dessen transparente Materialschichten höhere Transparenzwerte oder auf die betreffenden Spektralbereiche abgestimmte Transparenzprofile aufweisen. Die Transparenz kann durch eine transparente Materialschicht oder mehrere davon, die übereinander liegen, bestimmt werden.

Der Begriff der externen Licht- oder Strahlungsquelle bezeichnet eine solche Quelle, die nicht Bestandteil des Verbundbauteils ist.

Die Trennung der Materialschichten kann entsprechend verschiedener Ausführungsformen die Trennung von zwei oder mehreren Materialschichten des Verbundbauteiles voneinander betreffen und durch die genannten Prozesse zur Schichttrennung an verschiedenen Grenzflächen des Verbundbauteils erfolgen.

So kann die mindestens eine Blitzlampe so konstruiert und betrieben werden, dass von der Lampe emittiertes UV-Licht durch die transparente Materialschicht, nachfolgend auch als erste Schicht bezeichnet, fällt und in der daran angrenzenden weiteren Materialschicht, nachfolgend auch als zweite Schicht bezeichnet, zu Zerstörung von Bindungen führt und somit die Trennung der Materialschichten nach sich zieht. Das UV-Licht kann dabei auch eine oder mehrere Materialschichten durchdringen, die transparent nach obiger Definition sind. Ergänzend kann des UV-Licht durch weitere nicht mehr unter die Definition fallende, jedoch UV-Licht in ausreichendem Maße passieren lassende, weitere Materialschichten treten. Letztere sollen nachfolgend auch als dritte, vierte usw. Schicht bezeichnet sein. Im ersten Fall erfolgt die Abtrennung der zweiten Schicht oder eines Schichtstapels darauf direkt von der transparenten Materialschicht. Im zweiten Fall erfolgt eine Abtrennung innerhalb eines Schichtstapels von weiteren Materialschichten. Auch eine Kombination von beiden Varianten durch nacheinander folgende Verfahrensschritte ist möglich.

In analoger Weise kann auch die Abtrennung durch Trennprozesse in verschiedenen Ebenen des Verbundbauteils erfolgen. Dazu wird die mindestens eine Blitzlampe so konstruiert und betrieben, dass das von der Lampe emittierte sichtbare Licht durch die transparente Materialschicht, die erste Schicht, fällt und von der daran angrenzenden weiteren Materialschicht, der zweiten Schicht, absorbiert wird zur Trennung beider Schichten voneinander durch Erwärmung.

Alternativ oder ergänzend fällt das Licht der Blitzlampe durch die erste Schicht und erwärmt die zweite Schicht, ohne diese zu abzutrennen. Durch Wärmeleitung in der zweiten Schicht wird die Grenzfläche zwischen der zweiten Schicht und einer dritten Schicht in solchen Maße erwärmt, sodass eine Trennung der zweiten von der dritten Schicht erfolgt.

In Abhängigkeit von den thermischen und Transmissions- sowie Absorptions-Eigenschaften der zweiten und darauffolgenden Schichten sind so auch andere Grenzflächen im gewünschten Maß zu erwärmen und die Materialschichten voneinander zu trennen.

Der mit einer Belichtung behandelte Anteil der Oberfläche des Verbundmaterials kann entsprechend verschiedener Parameter, wie dem Schichtaufbau des Verbundbauteils, dessen Materialien mit deren physikalischen und chemischen Eigenschaften, der Gesamtgröße des Verbundbauteils, der für den verwendeten thermischen Prozess benötigten und mit der Lichtquelle erzielbaren Leistungsdichte, dem zur Verfügung stehenden Platz und anderen Parametern, sehr unterschiedlich gewählt werden. In Experimenten wurde gezeigt, dass ein Feld mehrerer zylinderförmiger Blitzlampen die gesamte Oberfläche eines Moduls homogen beleuchten kann, sodass beispielsweise bei Photovoltaikmodulen die Trennung der Glasscheiben des gesamten Moduls innerhalb weniger als einer Sekunde möglich ist. Damit reduziert sich der zeitliche Aufwand im vorhergehenden Beispiel für einen Solarpark von vielen Jahren auf unter einen Monat. Hinzu kommt, dass die Investitionskosten für das Feld der Blitzlampen nur einen Bruchteil der Kosten für den Laser gemäß Stand der Technik ausmachen. Durch geeignete Konfiguration der einen oder mehreren Blitzlampen können Flächenanteile in Prozentschritten individuell eingestellt werden, Für verschiedene Anwendungen, beispielsweise für Photovoltaik-Module, Displays, Komponenten von "ConcentratedSolar Power"-Anlagen und anderen, hat sich eine effektive Trennung deren Materialschichten entsprechend einer Ausgestaltung des Verfahrens bei einer Bestrahlung eines Anteils der bestrahlten Oberfläche von mindestens 5%, bevorzugt mindestens 10% herausgestellt, wobei auch höhere und geringere Anteile sowie Anteile zwischen den genannten Werten möglich sind.

Die Höhe des gleichzeitig und homogen bestrahlten Anteils kann durch eine Optimierung der Effizienz des Verfahrens und dessen Anpassung an den jeweiligen Anwendungsfall, wie Material und Design des Verbundbauteils, Lichtquelle und anderes, festgelegt werden. Dabei kann berücksichtigt werden, dass der prozentuale Flächenanteil eines physikalisch bedingten Intensitätsabfalls am Rand eines Belichtungsfeldes mit zunehmender Belichtungsfläche sinkt. Weiter lassen sich energetische Verluste infolge notwendiger Überlappung mehrerer, kleiner Belichtungsfelder im Vergleich zu einem größeren oder einzigen das gesamte Verbundbauteil abdeckenden Belichtungsfeld reduzieren. Zudem kann unerwünschte Degradation infolge der Überlappung der Belichtungsfelder und der dadurch bedingten Mehrfachbelichtung von bereits voneinander getrennten Materialien vermieden oder zumindest vermindert werden. Die Verwendung zumindest einer Blitzlampe gestattet die Bereitstellung der für großflächige Belichtungen erforderlichen Energie.

Als lichtabsorbierendes Material kommen verschiedene Materialien in Betracht. So kann es beispielsweise aus Silizium bestehen. Das schließt ein, dass die lichtabsorbierende Materialschicht weitere Materialien umfasst, beispielsweise Verunreinigungen oder ergänzende Materialbestandteile, die in solch einem Umfang vorhanden sind, dass die lichtabsorbierende Funktion der Materialschicht für den Trennprozess gewährleistet ist.

Bei einer beispielhaften, jedoch nicht beschränkenden Anwendung des Verfahrens auf ein Dünnschichtsolarmodul werden mit Hilfe einer ersten Belichtung die Glasscheiben als zwei Materialschichten eines Moduls voneinander getrennt. Je nach Bauart des Moduls befinden sich nach der Trennung noch unterschiedliche Materialschichten auf den beiden nun vorliegenden Komponenten des Verbundbauteils, üblicherweise den beiden Glasscheiben. Bei einer zweiten Belichtung der jeweiligen Komponenten, die i.a. mit einer höheren Intensität durchgeführt wird, wird eine weitere Zerlegung der Materialschichten ermöglicht. Beispielsweise besteht die stromerzeugende Schicht eines Dünnschichtsolarmoduls aus zwei Elektrodenschichten wie Molybdän und einem transparenten leitfähigen Oxid sowie einer dazwischen befindlichen Schicht, welche das Sonnenlicht absorbiert und in Strom umwandelt. Die Haftung der einzelnen Materialien aufeinander sowie deren Lichtabsorption sind verschieden groß, sodass es möglich ist die Stoffe der stromerzeugenden Schicht ohne die Einwirkung von Chemikalien voneinander zu trennen. Der wichtigste Schritt bleibt die Trennung der Glasscheiben von den restlichen Komponenten, da diese den größten Gewichts- und Volumenanteil von über 90% ausmachen. Vorausgesetzt wird dabei, dass elektrische Anschlüsse und ggf. Rahmen von dem Modul bereits entfernt wurden.

Bei sogenannten CIGS-Dünnschichtmodulen wird in der Produktion die stromerzeugende Schicht typischerweise auf dem Rückseitenglas (Glas auf der sonnenabgewandten Seite des Moduls) abgeschieden und anschließend mit Hilfe der EVA-Folie mit dem Frontseitenglas (Glas auf der sonnenzugewandten Seite des Moduls) verbunden. In diesem Fall kann in einer ersten Belichtung bei relativ geringer Intensität und einer Dauer von beispielsweise einer Millisekunde das Rückseitenglas vom Frontseitenglas aufgrund von thermo-mechanischen Spannungen, die durch die hohen Temperaturgradienten entstehen, getrennt werden. Die maximale Prozesstemperatur liegt regelmäßig unterhalb der Verdampfungstemperatur der zu trennenden Materialien. Dabei bleibt die Molybdän-Elektrode der CIGS-Schicht auf dem Rückseitenglas und die restlichen Materialien der stromerzeugenden Schicht inklusive EVA-Folie auf dem Frontseitenglas haften. Danach kann die Molybdän-Schicht vom Rückseitenglas durch eine zweite Belichtung bei einer höheren Intensität, aber ähnlichen Dauer entfernt werden, wiederum aufgrund thermo-mechanischer Spannungen. Die abgetrennte Molybdän-Schicht fällt in Form von Partikeln z.B. durch einen Luftstrom in einen Auffangbehälter nach dem Prinzip eines Staubsaugers.

Alternativ können die Partikel durch Gravitation bedingt in eine unter dem Modul liegenden Wanne fallen. Ebenso können die restlichen Materialien der stromerzeugenden Schicht von der EVA-Folie, welche auf dem Frontseitenglas haftet, entfernt werden aufgrund des temperaturbedingten Aufbrechens chemischer Verbindungen und als Partikel in einem zweiten Auffangbehälter gesammelt werden. Somit ist es möglich, Molybdän von den restlichen Materialien der stromerzeugenden Schicht ohne den Einsatz von Chemikalien zu trennen. Bei einer dritten Belichtung der Frontglasscheibe mit einer Dauer von beispielsweise 500 Millisekunden und einer relativ geringen Intensität kommt es zur Ablösung der EVA-Folie.

Somit ist der Materialverbund des CIGS-Moduls in zwei separate Glasscheiben, Molybdän-Partikel, CIGS-Partikel ohne Molybdän sowie die EVA-Folie zerlegt. Im Gegensatz zu anderen Recycling-Methoden kommt weder das Frontseitenglas noch das Rückseitenglas mit Chemikalien in Berührung, sodass auch eine Reinigung der Gläser vor der weiteren Verwertung entfallen kann. Je nach Bauart des Verbundbauteils und die dabei verwendeten Materialien ist es sinnvoll, die Betriebsparameter der Blitzlampen hinsichtlich Belichtungsdauer, Lichtintensität sowie Anzahl der Belichtungen anzupassen.

Gemäß einer Ausgestaltung des Verfahrens kann die Zerlegung der Module durch eine mobile Einheit durchgeführt werden, welche, gegebenenfalls teilweise in Komponenten unterteilt, in einem standardisierten Frachtcontainer Platz findet, der allgemein auch als ISO-Container, Fracht- oder Schiffscontainer oder Seefracht-Container bezeichnet wird und für Schiffs-, Eisenbahn- und Lkw-Transporte grenzübergreifend zur Anwendung kommt. Derartige Frachtcontainer sind genormte Großraumbehälter aus Stahl, die ein einfaches und schnelles Verladen, Befördern, Lagern und Entladen von Gütern ermöglichen. Mithilfe des Frachtcontainers wird die mobile Einheit zu einem Solarpark oder Recycling-Hof oder einer Produktionsstätte für Photovoltaik-Module oder allgemein zum Ort des Bedarfs der Verbundbauteile transportiert, d. h. dem Ort ihres Betriebs oder Lagerung oder Herstellung oder sonstigen Orts an welchem die Verbundbauteile recycelt werden sollen . Anschließend wird die Glasscheibe des Verbundbauteils oder mehrere davon, welche den überwiegenden Gewichtsanteil des Verbundbauteils ausmachen können und im Vergleich zu den üblichen Recycling-Verfahren nur wenige Verunreinigungen nach der Zerlegung enthalten, von den übrigen Schichtmaterialien mit dem zuvor beschriebenen Verfahren getrennt und direkt zum Glaswerk für eine Wiederverwendung transportiert. Die anderen Materialien, welche nur einen relativ geringen Gewichtsanteil aufweisen, werden zu den entsprechenden Recycling-Standorten zur weiteren Aufbereitung und Verwertung transportiert. Die mobile Einheit spart hohe Kosten durch kürzere Transportwege hinsichtlich der zu befördernden Mengen an Glas. Bei einem Modulgewicht von beispielsweise 15 Kilogramm ergeben sich ca. 30 Tausend Tonnen an Glas für das zuvor skizzierte Solarfeld mit einer maximalen Leistung von 300 Megawatt. Konventionelle Recycling-Anlagen mit einem produktionsüblichen Materialdurchsatz füllen ganze Hallen, sodass eine mobile Version in einem ISO-Container nicht realisiert werden kann.

Photovoltaik-Module, welche mit Hilfe von Silizium-Wafern Strom generieren, bilden den überwiegenden Anteil aller installierten Module und werden es noch für viele Jahre bleiben, allein schon aufgrund der existierenden Produktionskapazitäten. Diese Module bestehen typischerweise und im Wesentlichen aus einem Frontseitenglas sowie einer nahezu wasser- und lichtundurchlässigen Rückseitenfolie auf der sonnenabgewandten Seite des Moduls. Bei neueren Modulen wird anstelle der wasserundurchlässigen Folie ein Rückseitenglas verwendet. Die Silizium-Wafer sind beispielsweise mit jeweils einer EVA-Folie auf deren Front- und Rückseite zwischen dem Frontseitenglas und der Rückseitenfolie eingebettet. Bei den derzeit am häufigsten produzierten Modulen kann aufgrund der lichtundurchlässigen Rückseitenfolie die Rückseite eines Wafers im Modul (sonnenabgewandte Seite des Wafers) nicht direkt belichtet und damit erwärmt werden, sodass nur eine Belichtung von der Frontseite (sonnenzugewandte Seite) in Frage kommt. Aufgrund der ungefähr ca. 150 bis 650-fach höheren Wärmeleitfähigkeit von Silizium im Vergleich zu Glas bzw. Kunststoff-Folien ist es aber möglich, die Frontseite mit Hilfe einer zeitlich relativ langen Belichtungsdauer von beispielsweise 50 Millisekunden den gesamten Wafer zu erwärmen gemäß Anspruch 4 und 5 der Erfindung, sodass sich die EVA-Folien auf Front- und Rückseite ablösen. Die dafür erforderliche Energie ist dabei wesentlich höher, bedingt durch die große Wärmekapazität der 150 µm bis 450 µm dicken Silizium-Wafer im Vergleich zu einer ca. 3 µm dicken, stromerzeugenden Schicht eines Dünnschichtsolarmoduls. Die Wärmeleitung der EVA-Folien, in die die Wafer eingebettet sind, ist allerdings wesentlich geringer im Vergleich zu Glas. Deshalb wird die Wärmeenergie in den Silizium-Wafern während der Belichtung weniger schnell abgeleitet im Gegensatz zu DünnschichtModulen. Somit ist der Energiebedarf bei Modulen, die auf Silizium-Wafer basieren deutlich geringer als man allein aufgrund der Dicke der lichtabsorbierenden Schicht erwarten würde.

Bei Dünnschichtsolarmodulen oder bei Wafer-basierten Photovoltaik-Modulen mit Rückseitenglas wird zur Erhöhung der Lebensdauer eine sogenannte Randverkapselung aus beispielsweise Butylkautschuk oder Silikon mit einer Breite von ungefähr 10 bis 15 Millimetern verwendet, welche am Rand des Moduls zwischen den Glasscheiben aufgebracht ist. Da sich üblicherweise die optischen und thermischen Eigenschaften der Randverkapselung von der restlichen Fläche des Moduls unterscheiden, kann es unter Umständen wünschenswert sein, die erste Belichtung zur Trennung der Glasscheiben in zwei Belichtungen aufzuteilen.

Dazu wird das Modul durch eine Schattenmaske partiell abgedeckt, welche bis auf dessen Rand die zu belichtende Seite abschattet, und danach eine erste Belichtung bei einer hohen Intensität durchgeführt. Vor einer zweiten Belichtung mit einer geringeren Intensität wird nun die Schattenmaske entfernt, sodass auch der ursprünglich abgeschattete Bereich belichtet wird und eine Trennung der Glasscheiben erfolgt. Anschließend kann mit einer dritten Belichtung für die jeweilige Glasscheibe eine weitere Zerlegung bei einer wiederrum hohen Intensität erfolgen. Würde man die Schattenmaske weglassen, so könnte die weitere Zerlegung durch eine dritte Belichtung nicht mehr möglich sein.

Die Schattenmaske lässt sich z.B. aus einer oder mehreren Metallplatten für eine relativ hohe Wärmekapazität mit einer Dicke von einem Millimeter fertigen, die auf einer Glasplatte als Trägermaterial der Maske aufgeklebt ist. Bei geringen Belichtungsenergien sind alternativ auch dünnere Metallschablonen verwendbar. Auch andere Ausführungen und Materialien der Schattenmasken sind möglich. In manchen Fällen kann es zweckmäßiger sein, eine erste Belichtung ohne Schattenmaske bei geringer Intensität durchzuführen und anschließend eine Schattenmaske für eine Belichtung bei einer hohen Intensität zu verwenden.

Die seither beschriebenen Verfahren lassen sich aufgrund des prinzipiell ähnlichen Aufbaus aus einer für sichtbares Licht transparenten Materialschicht und einer daran angrenzenden, lichtabsorbierenden Materialschicht eines Verbundbauteils auch auf Displays anwenden. Ebenso gilt dies für Komponenten bei"Concentrated Solar Power", welche sich im Wesentlichen aus einem Spiegel auf einem Glasträger und aus einer lichtabsorbierenden Schicht auf einem Glasrohr zusammensetzen kann. Durch die Krümmung des Spiegels bedingt, wird das Sonnenlicht auf das Glasrohr konzentriert, welches durch Absorption eine durch das Rohr gepumpte Flüssigkeit erwärmt. Obgleich die dünne Schicht des Spiegels einen erheblichen Anteil des von der Blitzlampe emittierten Lichts reflektiert, reicht das im UV-Bereich absorbierte bzw. emittierte Licht aus, um die dünne Schicht vom Glasträger zu trennen. Bei dem lichtabsorbierenden Rohr hingegen führt schon eine relativ geringe Intensität bei der Belichtung zu einer Ablösung der lichtabsorbierenden Schicht.

Beim Rastern eines punktförmigen Laserstrahls auf der Oberfläche eines Verbundbauteils gemäß des eingangs geschilderten Standes der Technik können Gasblasen an der Grenzfläche der zu trennenden Materialschichten am Ort des Laserstrahls entstehen. Da zur Belichtung der gesamten Oberfläche des Moduls mehrere Minuten verstreichen, trägt der lokal entstehende Gasdruck durch den Strahl nur wenig zur Separation der Glasscheiben bei, insbesondere wenn das während der Belichtungszeit entstehende Gas entweichen kann. Im Gegensatz dazu kann bei der Erfindung die plötzliche Entstehung eines Gasvolumens an der gesamten Grenzfläche der zu trennenden Materialschichten eines Moduls in weniger als einer Sekunde zur Separierung der Schichten beitragen, wie dies im Fall eines Feldes von Blitzlampen zutrifft. Idealerweise wird dabei 100% der Grenzfläche eines Moduls in weniger als einer Sekunde gleichzeitig belichtet. In manchen Fällen reicht aber schon eine Belichtung von ungefähr 10% der Grenzfläche aus, um den Gasdruck für die Trennung der Materialschichten zu nutzen. Im letzteren Fall wären insgesamt ungefähr zehn aufeinanderfolgende Belichtungen bei gleicher Intensität und Belichtungsdauer erforderlich, um die gesamte Grenzfläche zu prozessieren.

Werden Blitzlampen mit hohen Stromdichten betrieben, z.B. als Blitzlampen mit einer Stromdichte von über 3000 Ampere pro Quadratzentimeter, so wird ein erheblicher Anteil des generierten Lichts im UV-Bereich emittiert. UV-Licht kann Bindungen in Kunststoffen aufbrechen oder Materialien erwärmen, die hauptsächlich im UV-Bereich Licht absorbieren, nicht aber im sichtbaren Bereich des Lichts wie beispielsweise Silberspiegel.

In anderen Fällen hingegen ist selbst ein geringer UV-Anteil für das Verfahren nicht erwünscht. Wenn beispielsweise sichtbares Licht durch einen in diesem Wellenlängenbereich transparenten Kunststoff fallen soll und ein daran angrenzendes Material im sichtbaren Bereich Licht absorbiert, erfolgt die Trennung der Materialschichten an der Grenzfläche durch Erwärmung. UV-Licht könnte eine Schädigung des Kunststoffs hervorrufen, sodass die Trennung der Materialien nicht an der Grenzfläche stattfindet, sondern beispielsweise in der Mitte der Kunststoffschicht. Beispielweise kann konstruktiv der Glaskörper einer Blitzlampe mit Cerium dotiert werden, sodass kein UV-Licht emittiert wird.

Eine Vorrichtung zur Ausführung eines der vorstehenden Verfahren umfasst eine Separationskammer oder mehrere davon und einer darin angeordneten externen Lichtquelle, wobei die Lichtquelle zumindest eine Blitzlampe ist, welche ausgebildet ist zur Bestrahlung eines Verbundbauteils mit Strahlungsdauern von weniger als einer Sekunde gemäß obiger Beschreibung. Als Separationskammer ist ein Arbeitsbereich bezeichnet, der derart umschlossen ist, dass außerhalb der Separationskammer befindliche Anlagekomponenten und die Arbeitskräfte vor Auswirkungen des Verfahrens, beispielsweise vor intensivem Licht, insbesondere UV-Licht, Lärm, Gasentwicklungen oder anderem, geschützt sind.

Optional können weitere Kammern oder in einer Kammer mehrere Sektionen mit zugehörigen Arbeits- und/oder Verbindungseinheiten angeordnet sein, welche ergänzenden Verfahrensschritten dienen. Das können das Handling, der Transport, vorbereitende Schritte wie Reinigung, die Maskierung oder die Lagerung von Verbundbauteilen oder deren Komponenten sein oder andere Arbeitseinheiten. Die Komponenten der Vorrichtung, welche der Ausführung der Verfahrensschritte dienen, sollen zusammenfassend als Separationsvorrichtung bezeichnet sein. Die Separationsvorrichtung kann als Clusteranlage oder als Inline-Anlage ausgebildet sein.

Optional kann die Vorrichtung mindestens einen standardisierten Frachtcontainer gemäß obiger Beschreibung umfassen, welcher geeignet ist zur Verwendung und/oder zum Transport der Separationsvorrichtung in dem zumindest einen Frachtcontainer. Das schließt ein, dass die Separationsvorrichtung in einem oder mehreren der Frachtcontainer angeordnet und das Verfahren zumindest größtenteils im Container ausführbar ist oder dass die Separationsvorrichtung, gegebenenfalls demontiert, in einem oder mehreren der Container Platz findet, so dass sie darin an den Ort des Bedarfs transportiert werden kann. Letzteres kann einschließen, dass die Separationsvorrichtung im Einsatz zumindest teilweise außerhalb des Containers angeordnet ist.

Die Erfindung soll nachfolgend anhand eines Ausführungsbeispiels beispielhaft und nicht beschränkend näher erläutert werden. Der Fachmann würde die zuvor und nachfolgend in den verschiedenen Ausgestaltungen der Erfindung realisierten Merkmale in weiteren Ausführungsformen kombinieren soweit es ihm zweckdienlich und sinnvoll erscheint. In den zugehörigen Zeichnungen zeigt
- Fig. 1: eine portable Vorrichtung zur Durchführung des erfindungsgemäßen Verfahrens in Draufsicht und
- Fig. 2: eine schematische Darstellung der Durchführung des erfindungsgemäßen Verfahrens innerhalb einer Elektrodenkammer.

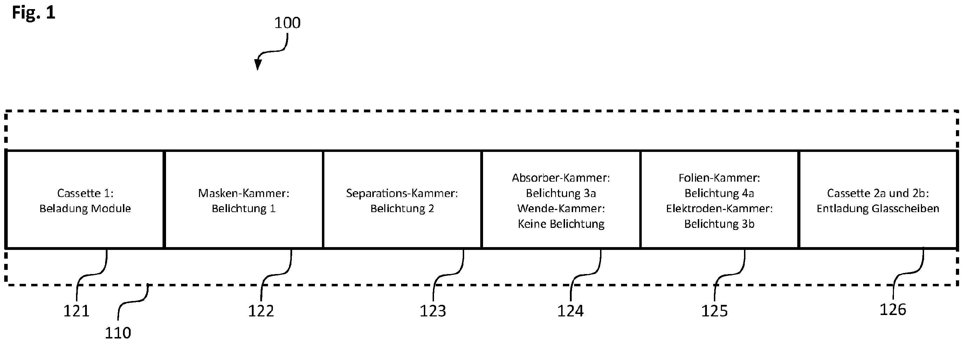

Figur 1 zeigt ein Beispiel für eine portable Vorrichtung (100) in Draufsicht, welche Platz in einem ISO-Container (1 10) findet, mit einer Länge von 40 Fuß. Die Vorrichtung besteht aus verschiedenen Segmenten (121) bis (126) mit einer Stellfläche von ca. 2.0 m x 1 .5m für jeweils mindestens einen Prozessschritt und Schleusen zwischen den Segmenten, um Licht-, Lärm-, Gas- oder Staubaustritt aus einem Segment während eines Belichtungsprozesses zu verhindern.

Werden die Segmente, wie in der Skizze gezeichnet, auf der zentralen Längsachse des Containers angeordnet, so ist jedes Segment für Wartungs- oder Reparaturarbeiten auch ohne Ausbau aus dem Container gut zugänglich. Bei der Beschreibung der Prozesse in den einzelnen Segmenten wurde im Folgenden auf die Zerlegung von zuvor beschriebene CIGS-Dünnschichtsolarmodule fokussiert, wobei sich geringe Unterschiede in manchen Segmenten für andere Bauarten von Verbundbauteilen, im Ausführungsbeispiel als Modul bezeichnet, ergeben können.

Im ersten Segment (121) befindet sich eine Cassette 1 mit horizontal und damit parallel zur Standfläche gestapelten Modulen, welche vor dem ersten Prozessschritt außerhalb des Containers befüllt wird, mit der Frontglasseite des Moduls auf der Oberseite in Bezug zur Decke des Containers. Aus dieser Cassette 1 wird ein Modul über ein Transportsystem, z.B. einem Transportband in das zweite Segment (122), der Masken-Kammer befördert und vor einer ersten Belichtung jeweils eine Schleuse zwischen dem ersten und zweiten Segment sowie zwischen dem zweiten und dritten Segment (123) geschlossen, um Licht-, Lärm-, Gas- oder Staubaustritt aus dem Segment (122) zu verhindern.

Anschließend wird eine Schattenmaske auf das Modul im Segment (122) auf die Frontglasseite von oberhalb des Moduls abgesenkt, die bei der ersten Belichtung bis auf die Randverkapselung alle Bereiche des Moduls abschattet, und dann das Modul durch die Schattenmaske hindurch von Blitzlampen oberhalb der Schattenmaske belichtet. Nach dieser ersten Belichtung wird zuerst die Schleuse zwischen Segment (122) und (123) geöffnet, danach das Modul in das Segment (123), der Separations-Kammer transferiert, die Schleuse zwischen Segment (122) und (123) wieder geschlossen, und schließlich das Modul ein zweites Mal belichtet, allerdings nun die gesamte Oberseite des Frontseitenglases.

Nach der zweiten Belichtung sind beide Glasscheiben des Dünnschichtmoduls nicht mehr miteinander verbunden. Mit Hilfe von z.B. Saugnäpfen wird nun das Frontseitenglas vom darunterliegenden Rückseitenglas abgenommen und anschließend in die Absorber-Kammer des Segments (124) gelegt, wobei sich auf dem Frontseitenglas noch die EVA-Folie sowie die stromgenerierende Schicht befinden. Das Rückseitenglas inklusive der darauf verbliebenen Molybdän-Schicht hingegen wird in die Wende-Kammer des Segments (124) weitertransportiert. Die Absorber-Kammer und die Wende-Kammer sind dabei beispielsweise übereinander angeordnet, sodass die jeweiligen Glasscheiben in voneinander getrennten Bereichen der Anlagen weiterbearbeitet werden können.

Vor einer dritten Belichtung (Belichtung 3a) des Frontseitenglases in der Absorber-Kammer wird die Schleuse zwischen der Absorber-Kammer des Segments (123) und des Segments (124) geschlossen. In der Wende-Kammer hingegen wird das Rückseitenglas umgedreht, sodass die Molybdän-Schicht nach unten zeigt. Bei der Belichtung 3a wird nun die stromgenerierende Schicht abgelöst. Nach dem Öffnen der Schleuse zwischen Segment (124) und Segment (125) wird das Frontseitenglas zunächst in die Folien-Kammer transportiert, in einem weiteren Schritt die Schleusen geschlossen und danach mittels einer vierten Belichtung (Belichtung 4a) die EVA-Schicht von dem Frontseitenglas separiert. In der darunterliegenden Elektroden-Kammer hingegen wird nun die Molybdän-Schicht vom Rückseitenglas mittels einer dritten Belichtung (Belichtung 3b) entfernt.

Das Frontseitenglas sowie das Rückseitenglas werden letztendlich in verschiedene Cassetten 2a und 2b im Segment (126) einsortiert, da diese Gläser typischerweise unterschiedliche Dicken und Materialzusammensetzungen aufweisen. Das Frontglas ist in der Regel ein Sicherheitsglas und hat eine höhere Transparenz aufgrund des geringeren Eisenanteils im Gegensatz zum Rückseitenglas.

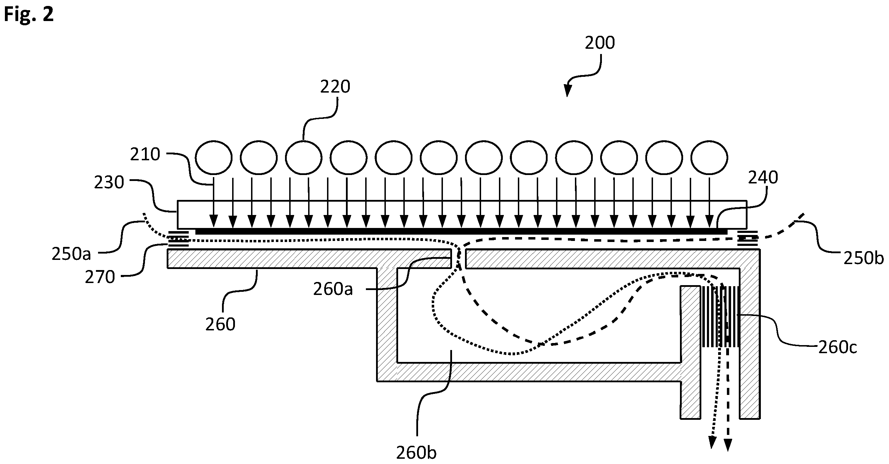

In Figur 2 ist der in der Elektroden-Kammer (200) des Segments (125) mit Hilfe der Belichtung 3a durchgeführte Prozess und Komponenten der Kammer exemplarisch dargestellt. Die Transportrichtung des Substrats bzw. die Längsrichtung des ISO-Containers ist senkrecht zur Blattebene. Die Skizze zeigt dabei einen vereinfachten Querschnitt des Anlagensegments, wobei die Gravitationskraft in der Blattebene nach unten gerichtet ist.

Ein Feld aus zylinderförmigen Blitzlampen (220) in Transportrichtung generiert Licht (210), welches durch das Rückseitenglas (230) hindurchfällt und von der Molybdän-Schicht (240) absorbiert wird. Ein Luftstrom 250a sowie ein weiterer Luftstrom 250b bläst die abgelösten Molybdän-Partikel (nicht dargestellt) in einem Kanal entlang, welcher sich durch einen Abstand zwischen dem Rückseitenglas und dem Ausschnitt der Anlagenwandung (260) bildet. Anschließend fallen die Partikel durch eine Öffnung (260a) hindurch in einen Auffangbehälter (260b), in dem ein Großteil der Partikel verbleibt. Der übrige Anteil der Molybdän-Partikel wird durch einen Staubfilter (260c) abgefangen, insbesondere Partikel mit sehr kleinem Gewicht, bevor der Luftstrom ins Freie geleitet wird. Für die Ausbildung des zuvor beschriebenen Kanals werden Abstandshalter (270) verwendet, welche für den Luftstrom 250a bzw. 250b durchlässig sind und für eine gleichmäßige Verteilung des Luftstroms auf der gesamten Fläche (240) sorgen.

### Bezugszeichenliste

- 100:: Portable Vorrichtung
- 110:: Umriss ISO-Container
- 121:: Cassette 1
- 122:: Masken-Kammer
- 123:: Separations-Kammer
- 124:: Absorber-Kammer und Wende-Kammer
- 125:: Folien-Kammer und Elektroden-Kammer
- 126:: Cassette 2a und Cassette 2b
- 200:: Querschnitt Elektroden-Kammer im Segment (125)
- 210:: Lichtstrahlen von Blitzlampen
- 220:: Feldzylinderförmige Blitzlampen
- 230:: Rückseitenglas
- 240:: Molybdän-Schicht auf Rückseitenglas (230)
- 250a:: Luftstrom
- 250b:: Luftstrom
- 260:: Ausschnitt Anlagenwandung
- 260a:: Öffnung in Anlagenwandung
- 260b:: Auffangbehälter
- 260c:: Staubfilter
- 270:: Abstandshalter

## Patentansprüche

1. Verfahren zum Trennen verschiedenartiger Materialschichten eines Verbundbauteils, welches mindestens eine für sichtbares Licht transparente Materialschicht, mit einer Transparenz über 40%, und mindestens eine weitere Materialschicht umfasst, wobei das Licht einer externen Quelle durch die mindestens eine transparente Materialschicht in die mindestens eine weitere Materialschicht fällt und dort zumindest teilweise absorbiert wird, so dass infolge der Erhitzung der lichtabsorbierenden weiteren Materialschicht mindestens zwei Materialschichten des Verbundbauteils voneinander getrennt werden, **dadurch gekennzeichnet, dass** das Licht der externen Quelle mit Hilfe von mindestens einer Blitzlampe bereitgestellt und damit die lichtabsorbierende weitere Materialschicht in einem Belichtungsfeld, welches mindestens einen Anteil der Oberfläche des Verbundbauteils umfasst, in weniger als einer Sekunde bestrahlt und erhitzt wird und dass die Strahlung im Belichtungsfeld zu einem Zeitpunkt der Belichtungsdauer eine konstante Intensität aufweist.

2. Verfahren nach Anspruch 1, **dadurch gekennzeichnet, dass** eine Trennung von zwei oder mehreren Materialschichten des Verbundbauteils voneinander mittels Schichttrennung an verschiedenen Grenzflächen des Verbundbauteils erfolgt.

3. Verfahren gemäß einem der vorstehenden Ansprüche, **dadurch gekennzeichnet, dass** die mindestens eine Blitzlampe so konstruiert und betrieben wird, dass von der Lampe emittiertes UV-Licht durch die transparente Materialschicht fällt und in zumindest einer Lage der das Licht absorbierenden weiteren Materialschicht zu Zerstörung von Bindungen und somit zur Trennung von aneinander angrenzenden Materialschichten des Verbundsystems führt.

4. Verfahren gemäß einem der vorstehenden Ansprüche, **dadurch gekennzeichnet, dass** die mindestens eine Blitzlampe so konstruiert und betrieben wird, dass das von der Lampe emittierte sichtbare Licht durch die transparente Materialschicht fällt und zur Erwärmung der das Licht absorbierenden weiteren Materialschicht und somit zur Trennung von aneinander angrenzenden Materialschichten des Verbundsystems führt.

5. Verfahren gemäß einem der vorstehenden Ansprüche, **dadurch gekennzeichnet, dass** eine weitere Materialschicht erhitzt wird, welche unmittelbar oder unter Zwischenlage einer anderen weiteren Materialschicht an die transparente Materialschicht angrenzt.

6. Verfahren gemäß einem der vorstehenden Ansprüche, wobei das lichtabsorbierende Material aus Silizium besteht.

7. Verfahren gemäß einem der vorstehenden Ansprüche, **dadurch gekennzeichnet, dass** der Anteil der bestrahlten Oberfläche des Verbundbauteils mindestens 5%, bevorzugt mindestens 10%, der Oberfläche beträgt.

8. Verfahren gemäß einem der vorstehenden Ansprüche, wobei für Verbundbauteile von mehr als zwei Materialschichten durch eine erste Belichtungsdauer bei einer ersten Intensität zwei Materialschichten des Verbundbauteils voneinander getrennt werden, sodass das Verbundbauteil durch die Trennung in zwei Komponenten zerlegt wird, und eine weitere Zerlegung zumindest einer Komponente des Verbundbauteils durch zumindest eine weitere Belichtungsdauer und zumindest eine weitere Intensität in weitere Komponenten erfolgt.

9. Verfahren gemäß Anspruch 8, wobei bei einer weiteren Zerlegung des Verbundbauteils mindestens einer der Parameter Belichtungsdauer und Intensität größer ist im Vergleich zu vorhergehenden Zerlegungen.

10. Verfahren gemäß Anspruch 8, wobei bei einer ersten Belichtung mindestens ein Teil des Verbundbauteils durch eine Schattenmaske abgedeckt ist und bei einer weiteren Belichtung ohne Schattenmaske mindestens einer der Parameter Belichtungsdauer und Intensität verschieden ist im Vergleich zu der ersten Belichtung mit Schattenmaske.

11. Verfahren gemäß Anspruch 9, wobei eine erste Belichtung ohne Schattenmaske durchgeführt wird und eine weitere Belichtung mit einer Schattenmaske.

12. Verfahren gemäß einem der vorstehenden Ansprüche, wobei das Verbundbauteil ein Photovoltaik-Modul, ein Display, eine Komponente im Bereich des "Concentrated Solar Power" ist.

13. Verfahren gemäß einem der Ansprüche 10 bis 12, wobei bei der ersten Belichtung eine Randverkapselung eines Photovoltaik-Moduls oder eines Displays belichtet wird.

14. Verfahren gemäß einem der vorstehenden Ansprüche, **dadurch gekennzeichnet, dass** mit Hilfe von mindestens einer Blitzlampe einer portablen Vorrichtung die Trennung mindestens einer Materialschicht, bevorzugt einer Glasschicht, eines Verbundbauteils von den anderen Materialschichten des Verbundbauteils am Ort des Bedarfs der Verbundbauteile erfolgt, wobei die Vorrichtung zum Trennen der Materialschichten, auch als Separationsvorrichtung bezeichnet, in mindestens einem standardisierten Frachtcontainer zumindest teilweise angeordnet ist.

## Claims

1. Method for separating heterogeneous material layers of a composite component which comprises at least one material layer transparent to visible light, having a transparency of more than 40%, and at least one further material layer, where the light from an external source falls through the at least one transparent material layer into the at least one further material layer, where it is at least partially absorbed, so that the heating of the light-absorbing further material layer causes separation of at least two material layers of the composite component from one another, **characterized in that** the light from the external source is provided by means of at least one flash lamp and is used to irradiate and heat the light-absorbing further material layer in an exposure field which encompasses at least a portion of the surface of the composite component, in less than one second, and **in that** the radiation in the exposure field has a constant intensity at one moment of the exposure period.

2. Method according to Claim 1, **characterized in that** a separation of two or more material layers of the composite component from one another takes place by means of layer separation at various interfaces of the composite component.

3. Method according to either of the preceding claims, **characterized in that** the at least one flash lamp is constructed and operated in such a way that UV light emitted by the lamp falls through the transparent material layer and leads, in at least one stratum of the light-absorbing further material layer, to destruction of bonds and thereby to the separation of material layers in the composite system that border one another.

4. Method according to any of the preceding claims, **characterized in that** the at least one flash lamp is constructed and operated in such a way that the visible light emitted by the lamp falls through the transparent material layer and leads to the heating of the light-absorbing further material layer and hence to the separation of material layers in the composite system that border one another.

5. Method according to any of the preceding claims, **characterized in that** a further material layer is heated which borders the transparent material layer directly or with interposition of another further material layer.

6. Method according to any of the preceding claims, where the light-absorbing material consists of silicon.

7. Method according to any of the preceding claims, **characterized in that** the proportion of the irradiated surface of the composite component is at least 5%, preferably at least 10%, of the surface.

8. Method according to any of the preceding claims, where the composite components of more than two material layers, two material layers of the composite component are separated from one another by a first exposure period at a first intensity, so that the composite component is broken down by the separation into two elements, and at least one element of the composite component is broken down further by at least one further exposure period and at least one further intensity into further elements.

9. Method according to Claim 8, where for a further breakdown of the composite component at least one of the parameters of exposure period and intensity is greater in comparison to preceding breakdowns.

10. Method according to Claim 8, where in a first exposure, at least a part of the composite component is masked by a shadow mask and in a further exposure without shadow mask at least one of the parameters of exposure period and intensity is different in comparison to the first exposure with shadow mask.

11. Method according to Claim 9, where a first exposure is carried out without shadow mask and a further exposure with a shadow mask.

12. Method according to any of the preceding claims, where the composite component is a photovoltaic module, a display or a "concentrated solar power" component.

13. Method according to any of Claims 10 to 12, where in the first exposure an edge encapsulation of a photovoltaic module or of a display is exposed.

14. Method according to any of the preceding claims, **characterized in that** by means of at least one flash lamp of a portable device, at least one material layer, preferably a glass layer, of a composite component is separated from the other material layers of the composite component at the location requiring the composite components, where the device for separating the material layers, also referred to as separating device, is at least partially disposed in at least one standardized freight container.

## Revendications

1. Procédé de séparation de différentes couches de matière d'un composant composite qui comprend au moins une couche de matière transparente à la lumière visible, d'une transparence supérieure à 40 %, et au moins une couche de matière supplémentaire, la lumière provenant d'une source extérieure étant incidente, via l'au moins une couche de matière transparente, à l'au moins une couche de matière supplémentaire où elle est au moins partiellement absorbée de manière à séparer au moins deux couches de matière du composant composite l'une de l'autre en conséquence de l'échauffement de la couche de matière supplémentaire photo-absorbante, **caractérisé en ce que** la lumière provenant de la source extérieure est produite à l'aide d'au moins une lampe flash et ainsi la couche de matière supplémentaire photo-absorbante est irradiée et chauffée en moins d'une seconde dans une zone d'éclairement qui comprend au moins une partie de la surface du composant composite et **en ce que** le rayonnement dans la zone d'éclairement a une intensité constante à un instant de la durée d'éclairement.

2. Procédé selon la revendication 1, **caractérisé en ce que** deux couches de matière ou plus du composant composite sont séparées l'une de l'autre par une séparation de couches au niveau de différentes surfaces limitées du composant composite.

3. Procédé selon l'une des revendications précédentes, **caractérisé en ce que** l'au moins une lampe flash est construite et utilisée de telle sorte que la lumière UV émise par la lampe traverse la couche de matière transparente et entraîne dans au moins une couche de la couche de matière supplémentaire photo-absorbante la destruction de liaisons et donc la séparation de couches de matière adjacentes du système composite.

4. Procédé selon l'une des revendications précédentes, **caractérisé en ce que** l'au moins une lampe flash est construite et utilisée de telle sorte que la lumière visible émise par la lampe traverse la couche de matière transparente et entraîne l'échauffement de la couche de matière supplémentaire photo-absorbante et donc la séparation de couches de matière adjacentes du système composite.

5. Procédé selon l'une des revendications précédentes, **caractérisé en ce qu'**une couche de matière supplémentaire est chauffée, laquelle est adjacente, immédiatement ou avec l'interposition d'une autre couche de matière supplémentaire, à la couche de matière transparente.

6. Procédé selon l'une des revendications précédentes, la matière photo-absorbante comprenant du silicium.

7. Procédé selon l'une des revendications précédentes, **caractérisé en ce que** la proportion de la surface irradiée du composant composite représente au moins 5 %, de préférence au moins 10 %, de la surface.

8. Procédé selon l'une des revendications précédentes, pour les composants composites de plus de deux couches de matière, deux couches de matière du composant composite étant séparées l'une de l'autre par une première durée d'éclairement à une première intensité de façon à décomposer le composant composite en deux composants par la séparation, et à effectuer une décomposition supplémentaire d'au moins un composant du composant composite en d'autres composants par au moins une durée d'éclairement supplémentaire et au moins une autre intensité.

9. Procédé selon la revendication 8, dans le cas d'une décomposition supplémentaire du composant composite, au moins un des paramètres parmi la durée d'éclairement et l'intensité étant supérieur par rapport aux décompositions précédentes.

10. Procédé selon la revendication 8, lors d'un premier éclairement au moins une partie du composant composite étant recouverte par un masque d'ombrage et lors d'un autre éclairement sans masque d'ombrage l'un au moins des paramètres parmi la durée d'éclairement et l'intensité étant différent par rapport au premier éclairement avec masque d'ombrage.

11. Procédé selon la revendication 9, un premier éclairement étant effectué sans masque d'ombrage et un autre éclairement étant effectué avec un masque d'ombrage.

12. Procédé selon l'une des revendications précédentes, le composant composite étant un module photovoltaïque, un afficheur, un composant dans le domaine des « Concentrated Solar Power » (centrales solaires thermodynamiques à concentration).

13. Procédé selon l'une des revendications 10 à 12, une encapsulation de bord d'un module photovoltaïque ou d'un afficheur étant éclairée pendant le premier éclairement.

14. Procédé selon la revendication précédente, **caractérisé en ce qu'**au moins une lampe flash d'un dispositif portable est utilisée pour séparer au moins une couche de matière, de préférence une couche de verre, d'un composant composite des autres couches de matière du composant composite à l'endroit où les composants composites sont nécessaires, le dispositif de séparation des couches de matière, également appelé dispositif de séparation, étant disposé au moins partiellement dans au moins un conteneur de fret normalisé.
